**Europäisches Patentamt**

**European Patent Office**

**Office européen des brevets**

(19)

(11) Numéro de publication : **0 011 570**
**B1**

# (12) FASCICULE DE BREVET EUROPÉEN

(45) Date de publication du fascicule du brevet :
22.09.82

(21) Numéro de dépôt : **79400865.6**

(22) Date de dépôt : **14.11.79**

(51) Int. Cl.³ : **H 03 H 15/02, H 01 L 27/10**

(54) **Dispositif de filtrage utilisant le transfert de charges électriques dans un semi-conducteur.**

(30) Priorité : **21.11.78 FR 7832765**

(43) Date de publication de la demande :
**28.05.80 (Bulletin 80/11)**

(45) Mention de la délivrance du brevet :
**22.09.82 Bulletin 82/38**

(84) Etats contractants désignés :
**DE GB NL**

(56) Documents cités :
**DE - A - 2 819 834**

**ARCHIV FUR ELEKTRONIK UND UBERTRAGUNGSTECHNIK, Vol. 32, no. 10, octobre 1978, pages 381-389 Stuttgart DE ; E. LUDER : « Integrierbare Filter in VLSI-Technik »**
**INSTITUTE OF ELECTRICAL AND ELECTRONICS ENGINEERS Intern. Conf. on Communications. San Fransisco ; June 16-18, 1975 New-York US. A. GERSHO : « Recursive filtering with charge transfer devices », page 2.15-2.19.**
**MICROELECTRONICS AND RELIABILITY ; Vol. 16, no. 4, 1977 ; pages 479-486 Oxford, GB K.U. LEVER : « Signal Processing with CCD transversal Filters ».**

(73) Titulaire : **THOMSON-CSF**
**173, Boulevard Haussmann**
**F-75360 Paris Cedex 08 (FR)**

(72) Inventeur : **Benoit-Gonin, Roger**
**"THOMSON-CSF" - SCPI 173, bld Haussmann**
**F-75360 Paris Cedex 08 (FR)**
Inventeur : **Forster, Daniel**
**"THOMSON-CSF" - SCPI 173, bld Haussmann**
**F-75360 Paris Cedex 08 (FR)**
Inventeur : **Picquendar, Jean-Edgar**
**"THOMSON-CSF" - SCPI 173, bld Haussmann**
**F-75360 Paris Cedex 08 (FR)**

(74) Mandataire : **Benichou, Robert et al**
**"THOMSON-CSF" - SCPI 173 bld Haussmann**
**F-75360 Paris Cedex 08 (FR)**

**EP 0 011 570 B1**

Imprimerie Jouve, 18, rue St-Denis, 75001 Paris, France

Dispositif de filtrage utilisant le transfert de charges électriques dans un semi-conducteur

La présente invention est relative à un dispositif de filtrage utilisant le transfert de charges électriques dans un semi-conducteur.

On rappelle qu'un filtre transversal à transfert de charges électriques, tel qu'en comporte le dispositif de filtrage selon l'invention, est généralement constitué par :

— un registre à décalages à transfert de charges électriques, réalisé sur un substrat semi-conducteur, recouvert d'une couche isolante sur laquelle sont disposées des électrodes de transfert, disposées parallèlement les unes aux autres et transversalement par rapport à la direction des charges.

Ces électrodes assurent sur application périodique de potentiels donnés le transfert dans substrat, d'un étage du registre au suivant, des paquets de charges correspondant à des échantillons du signal d'entrée à filtrer :

— des moyens de pondération reliés à la sortie des étages du registre à décalages qui affectent d'un coefficient de pondération la quantité de charges ayant parcouru chaque étage.

Les quantités de charges pondérées sont généralement lues différentiellement et ce signal différentiel constitue le signal électrique de sortie du dispositif.

Les filtres transversaux à transfert de charges sont notamment utilisés comme filtres passe-bas et passe-bande. Lorsqu'on désire obtenir de ces filtres une courbe de réponse en fréquence définie de façon rigoureuse, notamment en ce qui concerne l'atténuation apportée par le filtre dans une bande de fréquence donnée et hors de cette bande, en ce qui concerne l'ondulation résiduelle en bande passante, et la pente de la zone de transition vers la bande passante, on doit augmenter fortement le nombre de coefficients de pondération et donc d'étages du registre à décalages. Un filtre transversal à transfert de charges comportant 500 étages a ainsi été décrit dans un article de la revue américaine « I.E.E.E. Journal of Solid-State circuits », volume SC 11, pages 75 à 84 de février 1976.

L'inconvénient essentiel des filtres transversaux à transfert de charges est donc leur encombrement. On doit aussi noter que lorsque le nombre d'étages devient grand, pratiquement lorsqu'il dépasse la cinquantaine, les performances obtenues avec ces filtres ne correspondent plus à celles que laisse prévoir la théorie.

La présente invention concerne un dispositif de filtrage utilisant le transfert de charges électriques dans un semi-conducteur qui comporte au moins un filtre analogique, du deuxième ordre au moins, en série avec un filtre transversal à transfert de charges, le(s) filtre(s) analogique(s) contribuant à diminuer dans une bande de fréquence donnée, l'affaiblissement apporté par le filtre à transfert de charges à sa tension d'entrée échantillonnée, de façon que dans cette bande de fréquence l'affaiblissement du dispositif de filtrage Aff = 20 log$_{10}$ E/S, E et S étant les tensions d'entrée et de sortie du dispositif, soit sensiblement nul et contribuant à augmenter, hors de cette bande de fréquence, l'affaiblissement apporté par le filtre à transfert de charges à sa tension d'entrée échantillonnée, de façon que hors de cette bande de fréquences, l'affaiblissement du dispositif soit très élevé. Le filtre transversal à transfert de charges est constitué par :

— un registre à décalages à transfert de charges comportant plusieurs étages, ce registre étant réalisé sur un substrat semi-conducteur recouvert d'une couche isolante, des électrodes de transfert, constituant ces étages, étant disposées sur la couche isolante, parallèlement les unes aux autres et transversalement par rapport à la direction des charges, et assuran sur application périodique de potentiels donnés, le transfert des charges dans le substrat d'un étage du registre au suivant ;

— des moyens assurant l'injection de charges correspondant à la tension électrique d'entrée échantillonnée du filtre à transfert de charges ;

— des moyens de pondération reliés à la sortie des étages du registre qui affectent d'un coefficient de pondération la quantité de charges ayant parcouru chaque étage ;

— des moyens fixant le signe des coefficients de pondération ;

— des moyens de sommation et de lecture des quantités de charges pondérées, ces moyens fournissant le signal électrique de sortie du filtre à transfert de charges ;

— des moyens ant l'évacuation des charges ayant parcou ernier étage du registre.

Dans un des m de réalisation préférés de l'invention, les filtres analogiques sont des filtres à capacités commutées, qui comportent chacun un ou plusieurs amplificateurs composés uniquement de capacités et de transistors MOS fonctionnant en commutation, et le filtre transversal à transfert de charges a tous ses coefficients de pondération positifs et ne comporte pas d'amplificateur différentiel.

La fonction de transfert d'un filtre transversal à transfert de charges ne comporte que des zéros de transmission et pas de pôles.

Lorsqu'au moins un filtre analogique, du deuxième ordre au moins, est mis en série avec un filtre transversal, il introduit des paires de pôles qui permettent de diminuer le nombre de zéros requis pour réaliser le filtrage avec ce filtre transversal uniquement. Le nombre d'étages du filtre transversal peut donc être diminué.

On connaît, notamment par l'article tiré de la publication « Microelectronics and reliability », volume 16, N° 4, 1977, pages 479 à 486, qui est intitulé « Signal processing with CCD transversal filters », des dispositifs de filtrage comportant un filtre transversal à transfert de charge associé à deux filtres analogiques :

— l'un de ces filtres est disposé avant l'entrée du filtre à transfert de charge et est utilisé pour limiter au domaine de fréquence utile la réponse en fréquence du filtre à transfert de charge, qui se reproduit à une fréquence qui dépend de la fréquence d'échantillonnage ;

— l'autre filtre est disposé après le filtre transversal à transfert de charge et est utilisé pour « lisser » le signal qu'il reçoit.

Contrairement à ce qui se passe dans notre invention, les deux filtres analogiques utilisés ne jouent qu'un rôle annexe et ne permettent pas, en particulier, de diminuer le nombre de zéros du filtre transversal requis pour réaliser un filtrage donné, et donc de diminuer le nombre d'étages du filtre transversal.

La présente invention a notamment pour avantages :

— pour réaliser un filtrage donné, de diminuer le nombre d'étages du filtre transversal à transfert de charges, les résultats pratiques coïncident alors la théorie et de bons résultats peuvent être obtenus ;

— de diminuer l'encombrement du dispositif, particulièrement dans le mode de réalisation où les filtres analogiques sont des filtres à capacités commutées comportant des amplificateurs constitués uniquement de transistors MOS et de capacités, et où le filtre transversal à transfert de charges a tous ses coefficients de pondération positifs et ne comporte donc pas d'amplificateur différentiel. Ce mode de réalisation se prête très bien à l'intégration de tout le dispositif sur un même substrat semi-conducteur.

Lorsqu'un filtre à transfert de charges à coefficients positifs est utilisé, l'invention conduit aux meilleures performances de filtrage au point de vue de la linéarité de transfert, du bruit rapporté par le dispositif de filtrage et de la dynamique obtenue pour un taux d'harmonique donné.

D'autres objets, caractéristiques et résultats de l'invention ressortiront de la description suivante donnée à titre d'exemple non limitatif et illustrée par les figures annexées qui représentent :

la figure 1, un mode de réalisation du dispositif selon l'invention, ainsi qu'un mode de réalisation d'un filtre transversal à transfert de charges et d'un filtre analogique du deuxième ordre ;

les figures 2a, b, c, d, des courbes montrant, schématiquement, en fonction du rapport des fréquences $f/f_c$, les variations de l'affaiblissement apporté par deux filtres analogiques, un filtre transversal à transfert de charges et un dispositif selon l'invention comportant ces deux filtres analogiques en série avec ce filtre à transfert de charges ;

la figure 3, un mode de réalisation d'un filtre transversal à transfert de charges à coefficients de pondération positifs ;

la figure 4, un mode de réalisation d'un amplificateur utilisé dans un filtre analogique à capacités commutées.

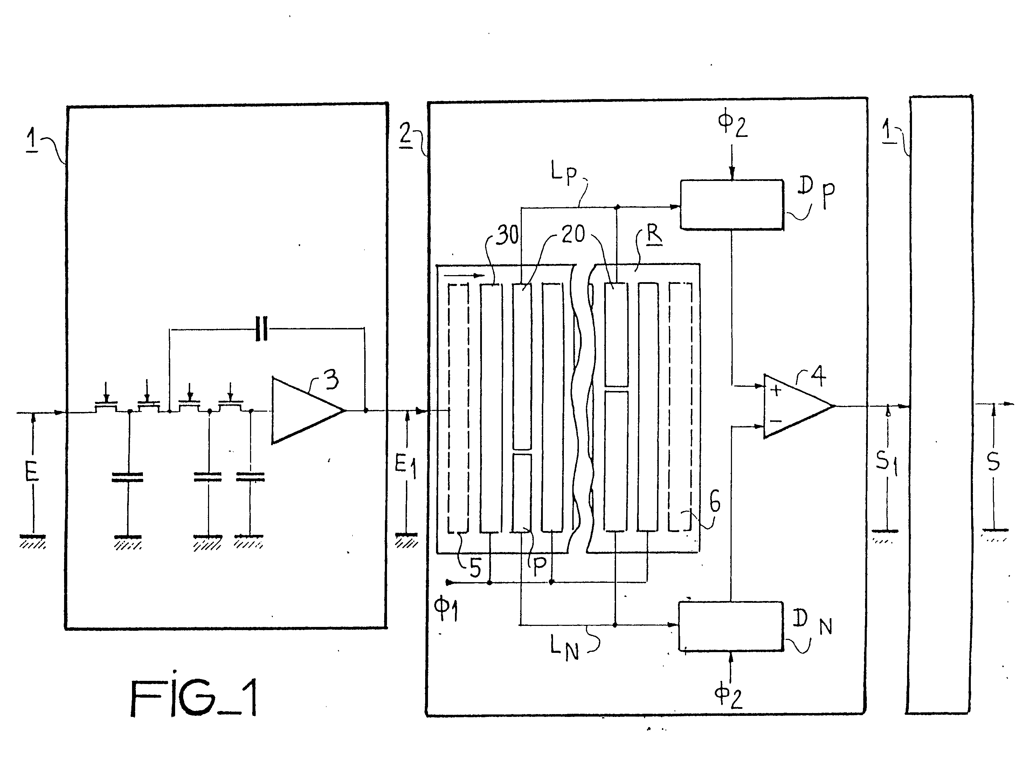

La figure 1 représente un mode de réalisation du dispositif selon l'invention. Deux filtres analogiques 1 sont montés en série avec un filtre transversal à transfert de charges 2, en aval et en amont de celui-ci. Sur la figure 1, deux filtres analogiques 1 sont représentés, mais l'invention s'applique aux cas où un ou plusieurs filtres analogiques sont montés en série avec un filtre transversal à transfert de charges. De même, l'invention couvre tous les modes de position relative du filtre à transfert de charges et du ou des filtres analogiques.

Les filtres analogiques doivent être au moins du deuxième ordre pour pouvoir diminuer, dans une bande de fréquence donnée, l'affaiblissement apporté par le filtre à transfert de charges, à sa tension d'entrée échantillonnée $E_1$. L'affaiblissement, Aff, est, par définition, égal à 20 $\log_{10}$ (tension d'entrée/tension de sortie). On rappelle qu'un filtre analogique, constitué de façon connue par un réseau de résistances, de selfs et de capacités, traite un signal analogique, par opposition aux filtres numériques, tels que les filtres à transfert de charges, qui traitent des échantillons du signal analogique à filtrer. Les filtres analogiques peuvent être aussi réalisés par combinaison d'un ou de plusieurs amplificateurs actifs, utilisant des transistors de type bipolaire ou MOS, et de réseaux de résistances et de capacités. Chaque résistance peut être également remplacée par une combinaison de deux transistors MOS fonctionnant en commutation et d'une capacité, les filtres ainsi réalisés sont appelés filtres à capacités commutées. De tels filtres ont été décrits notamment dans la revue américaine « I.E.E.E. Journal of Solid-State Circuits » Volume SC 12 Numéro 6, de décembre 1977, pages 592 à 608. Sur la figure 1, est représenté un mode de réalisation d'un filtre analogique 1, du deuxième ordre, à capacités commutées.

Il comporte un amplificateur 3 et un réseau de capacités et de transistors MOS, représenté à titre d'exemple. Sur la figure 1 est également représenté un mode de réalisation d'un filtre transversal à transfert de charges 2. Dans ce mode de réalisation, les moyens de pondération sont constitués par des électrodes de pondération 20 intercalées sur le registre à décalages R avec les électrodes de transfert 30. Chaque électrode de pondération est divisée en au moins deux électrodes élémentaires séparées selon la direction du transfert des charges par une coupure, une quantité de charges pondérée peut donc être recueillie sous chaque électrode élémentaire. Sur la figure 1, à titre d'exemple, une seule électrode de transfert est intercalée entre chaque électrode de pondération et chaque électrode de pondération est divisée en deux électrodes élémentaires. Sur la figure 1, les moyens de lecture sont constitués de façon connue par deux dispositifs de lecture des charges en courant ou en tension $D_P$ et $D_N$. Ces dispositifs réalisent la conversion des charges en tension de sortie, et sont couplés à deux lignes de recueil $L_P$ et $L_N$ des quantités de charges pondérées de deux électrodes élémentaires de chaque électrode de pondération. Les moyens fixant le signe des coefficients de pondération et les moyens de sommation des quantités de charges pondérées comportent un amplificateur différentiel 4 de gain unité recevant les signaux issus des dispositifs de lecture de charges et fournissant le signal de sortie $S_1$ du filtre à transfert de charges. Les électrodes de transfert et de pondération assurent sur application périodique de potentiels donnés, respectivement $\phi_1$ et $\phi_2$, le transfert des charges dans le substrat. Le potentiel $\phi_2$ peut être appliqué aux électrodes élémentaires sous lesquelles des charges sont prélevées par l'intermédiaire des dispositifs de lecture, $D_P$ et $D_N$. Les moyens d'injection et d'évacuation des charges sont représentés symboliquement et repérés par 5 et 6.

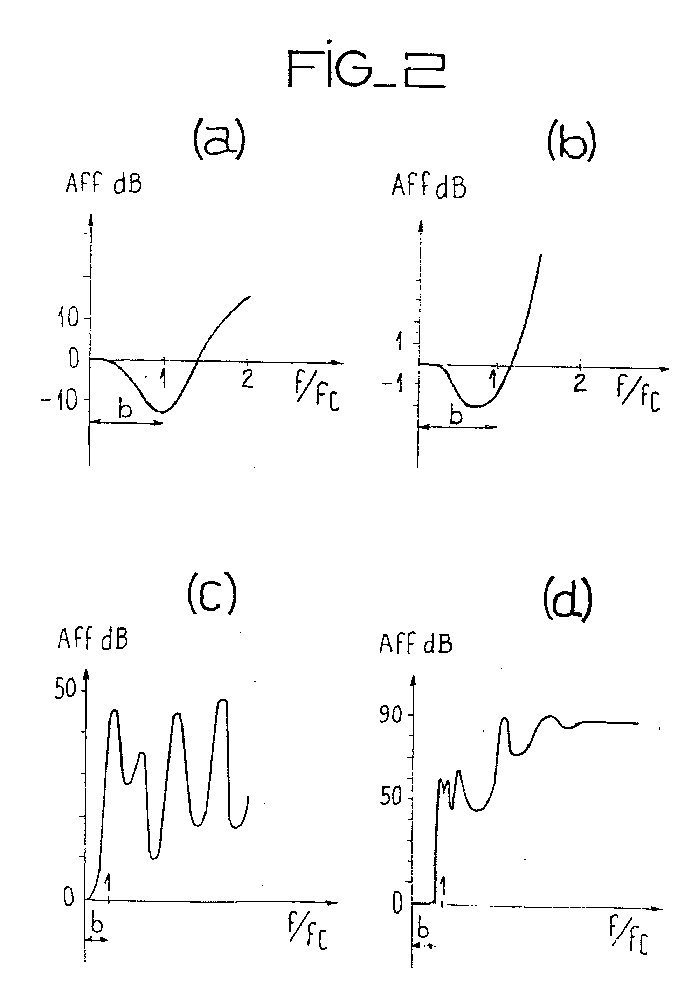

Les figures 2a, b, c, d, représentent des courbes montrant schématiquement les variations de l'affaiblissement apporté par deux filtres analogiques, un filtre transversal à transfert de charges et un dispositif selon l'invention comportant ces deux filtres en série avec le filtre à transfert de charges, en fonction du rapport $f/f_c$, f étant la fréquence de fonctionnement et $f_c$ la fréquence de coupure du dispositif.

Les filtres analogiques diminuent dans la bande de fréquence b, figures 2a et b, l'affaiblissement apporté par le filtre à transfert de charges à sa tension d'entrée échantillonnée, figure 2c. Le dispositif selon l'invention a ainsi un affaiblissement, Aff $= 20 \log_{10} E/S$, E et S étant les tensions d'entrée et de sortie du dispositif, sensiblement nul dans la bande b, figure 2d. Les filtres analogiques augmentent hors de la bande b l'affaiblissement dû au filtre transversal à transfert de charges. Hors de la bande b, l'affaiblissement du dispositif est très élevé et supérieur à 40 décibels.

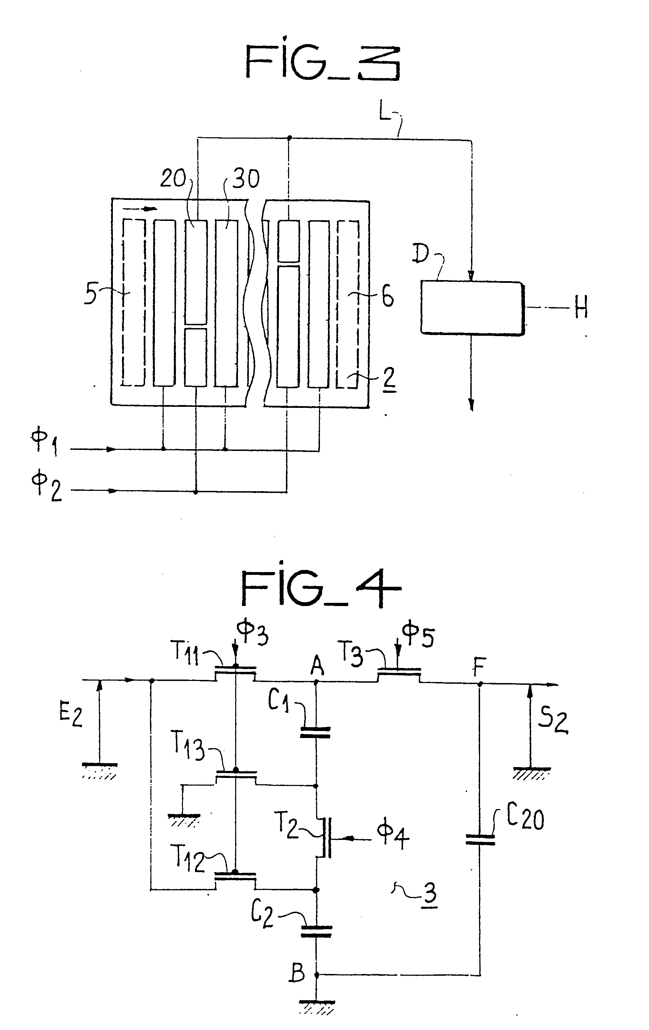

La figure 3 représente un mode de réalisation d'un filtre transversal à transfert de charges à coefficients de pondération positifs. Une quantité de charge pondérée est recueillie sous l'une des électrodes élémentaires de chaque électrode de pondération 20 par une ligne de recueil L, constituant les moyens de sommation du filtre transversal. Les moyens de lecture des quantités de charges électriques et les moyens fixant le signe des coefficients de pondération sont constitués par un dispositif de lecture des charges, en courant ou en tension D, couplé à la ligne de recueil, et fournissant le signal électrique de sortie du filtre.

Le dispositif D reçoit un signal d'horloge H de même fréquence que les signaux $\phi_1$ et $\phi_2$.

Un filtre transversal à transfert de charges à coefficients de pondération positifs présente l'avantage de ne pas comporter d'amplificateur différentiel, toujours difficile à intégrer.

La figure 4 représente un mode de réalisation d'un amplificateur qui peut être utilisé dans un filtre analogique à capacités commutées, tel que l'amplificateur 3 représenté sur la figure 1. Dans le mode de réalisation de la figure 4 le gain de l'amplificateur est sensiblement égal à 2. Cet amplificateur comporte deux capacités $C_1$ et $C_2$ qui sont périodiquement commutées en parallèle et en série par des transistors MOS fonctionnant en commutation. Une même tension $E_2$ charge simultanément les capacités commutées en parallèle et une tension amplifiée est obtenue entre les bornes extrêmes A et B des capacités commutées en série. Les deux capacités sont commutées en parallèle par les transistors MOS $T_{11}$ et $T_{12}$, connectés par leur drain et leur source entre d'une part la borne extrême A de la capacité $C_1$, et une borne de la capacité $C_2$ autre que la borne extrême B et d'autre part l'entrée où est appliquée une tension $E_2$ et par le transistor MOS $T_{13}$, connecté par son drain et sa source, entre une borne de la capacité $C_1$ autre que la borne extrême A et la masse. La borne extrême B est reliée directement à la masse. Les deux capacités sont commutées en série par un transistor MOS $T_2$ connecté par son drain et sa source entre les bornes des deux capacités autres que les bornes extrêmes A et B. Les deux groupes de transistors MOS, $T_{11}$, $T_{12}$, $T_{13}$, et $T_2$, sont commandés par des signaux périodiques $\phi_3$ et $\phi_4$ appliqués à leurs grilles et tels que les deux groupes ne soient pas simultanément conducteurs.

Entre la borne extrême A et un point F, on peut connecter par son drain et sa source un transistor MOS $T_3$, commandé en commutation par un signal périodique $\phi_5$ appliqué à sa grille. Le transistor $T_3$ est rendu conducteur pendant l'intervalle de temps où les capacités sont commutées en série par le signal $\phi_4$ pour permettre le transfert de la tension amplifiée de la borne A vers le point F. Une capacité $C_{20}$, peut être connectée entre le point F et la masse. Elle permet le maintien au point F de la tension amplifiée $S_2$ et l'ajustage du gain de l'amplificateur. La tension $S_2$ en F après la conduction de $T_3$ s'écrit dans le cas où les deux capacités ont la même valeur C :

$$S_2 = E_2 \cdot \frac{2}{1 + 2 \cdot C_{20}/C}$$

On réalise aisément un amplificateur de gain supérieur à 2 en augmentant le nombre des capacités à commuter telles que $C_1$ et $C_2$ sur la figure 4 et le nombre de transistor, tels que $T_2$, $T_{11}$, $T_{12}$, $T_{13}$, servant à réaliser la commutation.

Un amplificateur à capacités commutées, tel que celui précédemment décrit, peut être facilement intégré sur un même substrat semi-conducteur puisqu'il se compose uniquement de capacités et de transistors MOS. Un filtre à capacités commutées comportant un ou plusieurs amplificateurs à capacités commutées peut donc être aisément intégré. Un autre avantage des amplificateurs à capacités commutées est leur gain très stable, bien défini et leur faible consommation.

Les deux capacités $C_1$ et $C_2$ de l'amplificateur à capacités commutées peuvent être confondues avec l'une des capacités appartenant au réseau de capacités et de transistors MOS relié à chaque amplificateur.

L'amplificateur représenté sur la figure 4 peut être complété par un montage suiveur, constitué par exemple par un seul transistor ou par un amplificateur différentiel bouclé.

Le dispositif selon l'invention peut être entièrement intégré sur un même substrat semi-conducteur dans les modes de réalisation où les filtres analogiques sont intégrables.

L'intégration de tout le dispositif sur le même substrat est d'autant plus aisée :

— que le filtre transversal à transfert de charges est à coefficients de pondération positifs ;

— que les filtres analogiques sont des filtres à capacités commutées comportant des amplificateurs à capacités commutées.

Tout dispositif qui diffère de ceux exposés par le mode de réalisation de ou des filtres analogiques ou par le mode de réalisation du filtre transversal à transfert de charges, notamment le nombre d'électrodes de transfert intercalées entre chaque électrode de pondération, le nombre d'électrodes élémentaires constituant chaque électrode de pondération ne sort pas du cadre de l'invention. Le dispositif selon l'invention est utilisé pour le filtrage de signaux électriques.

## Revendications

1. Dispositif de filtrage utilisant le transfert de charges électriques dans un semi-conducteur, comportant au moins un filtre analogique (1), en série avec un filtre transversal à transfert de charges électriques (2) constitué par :

— un registre à décalages à transfert de charges (R) comportant plusieurs étages, ce registre étant réalisé sur un substrat semi-conducteur recouvert d'une couche isolante, des électrodes de transfert (30), constituant ces étages, étant disposées sur la couche isolante, parallèlement les unes aux autres et transversalement par rapport à la direction des charges et assurant, sur application périodique de potentiels donnés, le transfert des charges dans le substrat d'un étage du registre au suivant ;

— des moyens assurant l'injection de charges (5) correspondant à la tension électrique d'entrée ($E_1$) échantillonnée du filtre à transfert de charges ;

— des moyens de pondération (P) reliés à la sortie des étages du registre qui affectent d'un coefficient de pondération la quantité de charges ayant parcouru chaque étage ;

— des moyens fixant le signe des coefficients de pondération ;

— des moyens de sommation et de lecture des quantités de charges pondérées, ces moyens fournissant le signal électrique de sortie ($S_1$) du filtre à transfert de charges ;

— des moyens (6) assurant l'évacuation des charges ayant parcouru le dernier étage du registre ; caractérisé en ce que le(s) filtre(s) analogique(s) sont du deuxième ordre au moins et contribuent à diminuer, dans une bande de fréquence donnée (b) l'affaiblissement apporté par le filtre à transfert de charges à sa tension d'entrée échantillonnée, de façon que dans cette bande de fréquence l'affaiblissement du dispositif de filtrage, $Aff = 20 \log_{10} E/S$, E et S étant les tensions d'entrée et de sortie du dispositif, soit sensiblement nul et à augmenter hors de cette bande de fréquence (b), l'affaiblissement apporté par le filtre à transfert de charges à sa tension d'entrée échantillonnée.

2. Dispositif selon la revendication 1, caractérisé en ce que les moyens de pondération sont constitués par des électrodes de pondération (20), intercalées sur le registre à transfert de charges (R) avec les électrodes de transfert (30), chaque électrode de pondération étant divisée en au moins deux électrodes élémentaires, séparées selon la direction de transfert des charges par une coupure, une quantité de charges pondérée pouvant être recueillie sous chaque électrode élémentaire, les électrodes de transfert et de pondération assurant sur application périodique de potentiels donnés ($\phi_1$, $\phi_2$) le transfert des charges dans le substrat.

3. Dispositif selon la revendication 2, caractérisé en ce que les moyens de lecture sont constitués par deux dispositifs de lecture des charges ($D_P$, $D_N$) couplés à deux lignes de recueil ($L_P$, $L_N$) des quantités de charges pondérées de deux électrodes élémentaires de chaque électrode de pondération (20) et en ce que les moyens fixant le signe des coefficients de pondération et les moyens de sommation des quantités de charges pondérées comportent un amplificateur différentiel (4) de gain unité recevant les signaux issus des dispositifs de lecture des charges et fournissant le signal électrique de sortie ($S_1$) du filtre à transfert de charges.

4. Dispositif selon la revendication 2, caractérisé en ce que le filtre à transfert de charges est à coefficients de pondération positifs, les moyens de sommation algébrique étant constitués par une ligne de recueil (L) des quantités de charges pondérée d'une électrode élémentaire de chaque électrode de pondération (20), les moyens de lecture des quantités de charges électriques et les moyens fixant le signe des coefficients de pondération étant constitués par un dispositif de lecture des charges (D), couplé à la ligne de recueil et fournissant le signal électrique de sortie du filtre.

5. Dispositif selon l'une des revendications 1, 2, 3 ou 4, caractérisé en ce qu'un filtre analogique au moins est un filtre à capacités commutées, constitué d'un amplificateur (3) au moins, et d'un réseau de capacités et de transistors MOS fonctionnant en commutation, qui est relié à chaque amplificateur et dans lequel la combinaison d'une capacité et de deux transistors MOS sert de résistance.

6. Dispositif selon la revendication 5, caractérisé en ce que chaque amplificateur (3) comporte des capacités ($C_1$, $C_2$), périodiquement commutées en parallèle et en série par des transistors MOS fonctionnant en commutation, une même tension chargeant simultanément les capacités commutées en parallèle et une tension amplifiée étant obtenue, entre les bornes extrêmes A et B des capacités commutées en série, les capacités étant commutées en parallèle par des transistors

MOS ($T_{11}$, $T_{12}$) connectés ~~ leur drain et leur source entre d'une part, ~~ne des bornes de chaque capacité parmi ~~esquelles la borne extrême A de la capacité $C_1$ et d'autre part, l'entrée où est appliquée une tension $E_2$, et par des transistors MOS ($T_{13}$) connectés par leur drain et leur source entre l'autre borne de chaque capacité et la masse, la borne extrême B étant reliée directement à la masse, et les capacités étant commutées en série par des transistors MOS ($T_2$) connectés par leur drain et leur source entre les bornes des capacités, autres que les bornes extrêmes A et B, les deux groupes de transistors MOS ($T_{11}$, $T_{12}$, $T_{13}$ ; $T_2$) assurant la commutation en parallèle et en série étant commandés par des signaux périodiques ($\phi_3$, $\phi_4$) appliqués à leurs grilles et tels que les deux groupes ne soient pas simul~~ ~~ment conducteurs, cet amplificateur pouvar~~ ~~e entièrement intégré sur un même substrat ~~-conducteur.

7. Dispositif selon la revend~~ ~~on 6, caractérisé en ce qu'un transistor MOS $T_3$ est connecté par son drain et sa source entre la borne extrême A et un point F, constituant la borne d'une capacité $C_{20}$ dont l'autre borne est connectée à la masse, le transistor MOS $T_3$ fonctionnant en commutation et étant commandé par un signal périodique $\phi_5$ appliqué à sa grille, le transistor $T_3$ étant rendu conducteur pendant l'intervalle de temps où les capacités sont commutées en série par le signal $\phi_4$ pour permettre le transfert de la tension amplifiée de la borne A vers le point F, la capacité $C_{20}$ permettant le maintien au point F de la tension amplifiée et l'ajustage du gain de l'amplificateur.

8. Dispositif selon l'une des revendications 6 ou 7, caractérisé en ce que les capacités ($C_1$, $C_2$) de l'amplificateur (3) sont confondues avec une capacité appartenant au réseau de capacités et de transistors MOS relié à chaque amplificateur.

9. Dispositif selon l'une des revendications 1 à 8, caractérisé en ce qu'il est entièrement intégré sur un même substrat semi-conducteur.

**Claims**

1. Filter device using the transfert of electric charges within a semi-conductor, comprising at least one analog filter (1) in series with a transverse electric charge transfer filter (2) formed by :
— a charge transfer shift register (R) comprising a plurality of stages, said register being formed on a semi-conductor substrate covered by an insulating layer, transfer electrodes (30) forming said stages being arranged on the insulating layer being parallel with each other and transverse with respect to the direction of the charges and assuring the charge transfer within the substrate from one regist~~ ~~r stage to the following upon periodic application of given potentials ;
— means (5) assuring the injection of charges corresponding to the sampled electric input voltage ($E_1$) of the charge transfer filter ;
— weighting means (P) connected to the output of the register stages and applying a weighting coefficient to the charge quantity having crossed each stage ;
— means fixing the sign of the weighting coefficients ;
— means for summing and reading the weighted charge quantities, said means providing the electric output signal ($S_1$) of the charge transfer filter ;
— means (6) assuring the evacuation of the charges having crossed the last stage of the register ; characterized in that the analog filter(s) is (are) of at least second order and contributes (contribute) to reduce the attenuation caused by the charge transfer filter at its sampled input voltage within a given frequency band (b), so that within this frequency band, the attenuation of the filte~~ ~~device, Aff = 20 $\log_{10}$ E/S, wherein E and S are ~~ input and output voltages of the device, is su~~ ~~tially zero and, outside this frequency ba~~ ~~b), the attenuation caused by the charge tran~~er filter on its sampled input voltage increases.

2. Device in accordance with claim 1, characterized in that the weighting means are formed by weighting electrodes (20) interdigitated on the charge transfer register (R) with the transfer electrodes (30), each weighting electrode being divided into at least two elementary electrodes separated in the charge transfer direction by a cut, a weighted charge quantity being adapted to be collected under each elementary electrode, the transfer and weighting electrodes assuring the transfer of the charges within the substrate upon periodic application of given potentials ($\phi_1$, $\phi_2$).

3. Device in accordance with claim 2, characterized in that the reading means are formed by two charge reading devices ($D_P$, $D_N$) coupled to two collecting lines ($L_P$, $L_N$) for collection of the weighted charge quantities of the two elementary electrodes of each weighting electrode (20), and in that the means fixing the sign of the weighting coefficients and the means for summing the weighted charge quantities comprise a differential amplifier (4) of unity gain receiving the signals delivered by the charge reading devices and providing the electric output signal ($S_1$) of the charge transfer filter.

4. Device in accordance with claim 2, characterized in that the charge transfer filter is of positive weighting coefficients type, the means for algebraic summing being formed by a line (L) for collection of the weighted charge quantities of one elementary electrode of each weighting electrode (20), the means for reading the electric charge quantities and the means fixing the sign of the weighting coefficients being formed by a device for reading the charges (D) coupled to the collection line and providing the electric output signal of the filter.

5. Device in accordance with any of claims 1, 2, 3 or 4, characterized in that at least one analog filter is a switched capacities filter formed by at least one amplifier (3) and a network of capacities and MOS transistors operating in the switching mode, which is connected to each amplifier and in which the combination of one capacity and two MOS transistors is used as a resistor.

6. Device in accordance with claim 5, characterized in that each amplifier (3) comprises capacities ($C_1$, $C_2$) periodially switched in parallel and in series by MOS transistors operating in the switching mode, the same voltage simultaneously charging the capacities when connected in parallel, and an amplified voltage being obtained between the end terminals A and B of the series connected capacities, the capacities being switched in parallel by MOS transistors ($T_{11}$, $T_{12}$) connected with their drain and their source between one of the terminals of each capacity, within which the end terminal A of the capacity $C_1$, on the one hand, and that input on which a voltage $E_2$ is applied, on the other hand, and by MOS transistors ($T_{13}$) connected with their drain and their source between the other terminal of each capacity and ground, the end terminal B being directly connected to ground, and the capacities being series connected by MOS transistors ($T_2$) connected with their drain and their source between the terminals of the capacities other than the end terminals A and B, the two MOS transistor groups ($T_{11}$, $T_{12}$, $T_{13}$ ; $T_2$) assuring the parallel and series connection being controlled by periodic signals ($\phi_3$, $\phi_4$) applied on their gates and of such kind that the two groups are not simultaneously conductive, said amplifier being adapted to be entirely integrated on one and the same semi-conductor substrate.

7. Device in accordance with claim 6, characterized in that one MOS transistor $T_3$ is connected on its drain and its source between the end terminal A and a point F forming the terminal of a capacity $C_{20}$ the other terminal of which is connected to ground, the MOS transistor $T_3$ operating in the switching mode and being controlled by a periodic signal $\phi_5$ applied on its gate, the transistor $T_3$ being controlled conductive during the time interval where the capacities are switched in series by the signal $\phi_4$ to allow the transfer of the amplified voltage from terminal A towards point F, the capacity $C_{20}$ allowing to maintain the amplified voltage at point F and the adjustment of the amplifier gain.

8. Device in accordance with any of claims 6 or 7, characterized in that the capacities ($C_1$, $C_2$) of the amplifier (3) are identical with a capacity belonging to the network of capacities and MOS transistors connected to each amplifier.

9. Device in accordance with any of claims 1 to 8, characterized in that it is entirely integrated on one and the same semi-conductor substrate.

**Ansprüche**

1. Filtervorrichtung, die die Überführung von elektrischen Ladungen in einem Halbleiter anwendet, mit wenigstens einem Analogfilter (1) in Reihe mit einem Transversalfilter (2), das mit Überführung elektrischer Ladungen arbeitet und gebildet ist aus :

— einem mit Ladungsverschiebung arbeitenden Schieberegister (R), das mehrere Stufen umfaßt und auf einem Halbleitersubstrat verwirklicht ist, das mit einer Isolierschicht bedeckt ist, wobei Verschiebeelektroden (30), welche diese Stufen bilden, auf der Isolierschicht zueinander parallel und transversal in Bezug auf die Richtung der Ladungen angeordnet sind und bei periodischem Anlegen gegebener Potentiale die Überführung der Ladungen in dem Substrat von einer Registerstufe zur nächsten gewährleisten ;

— Mitteln (5), welche die Injektion von Ladungen gewährleisten, die der abgetasteten elektrischen Eingangsspannung ($E_1$) des Ladungsverschiebefilters entsprechen ;

— Wichtungsmitteln (P), die mit dem Ausgang der Registerstufen verbunden sind und die Menge der Ladungen, die jede Stufe durchquert haben, mit einem Wichtungskoeffizienten behaften ;

— Mitteln, die das Vorzeichen der Wichtungskoeffizienten festlegen ;

— Mitteln zum Summieren und Auslesen der gewichteten Ladungsmengen, wobei diese Mittel das elektrische Ausgangssignal ($S_1$) des Ladungsverschiebefilters liefern ;

— Mitteln (6), die eine Beseitigung der Ladungen gewährleisten, die die letzte Registerstufe durchlaufen haben ; dadurch gekennzeichnet, daß das (die) Analogfilter wenigstens von der zweiten Ordnung ist (sind) und dazu beiträgt (beitragen), in einem gegebenen Frequenzband (b) die Schwächung zu vermindern, die durch das Ladungsverschiebefilter an ihrer abgetasteten Eingangsspannung bewirkt wird, so daß in diesem Frequenzband die durch die Filtervorrichtung verursachte Dämpfung Aff = $20 \log_{10}$ E/S, wobei E und S die Eingangsspannung bzw. Ausgangsspannung der Vorrichtung ist, im wesentlichen gleich Null ist und außerhalb dieses Frequenzbandes (b) die durch das Ladungsverschiebefilter an ihrer abgetasteten Eingangsspannung verursachte Dämpfung zunimmt.

2. Vorrichtung nach Anspruch 1, dadurch gekennzeichnet, daß die Wichtungsmittel gebildet sind aus Wichtungselektroden (20), die an dem Ladungsverschieberegister (R) mit den Überführungselektroden (30) verschachtelt sind, wobei jede Wichtungselektrode in wenigstens zwei Elementarelektroden unterteilt ist, die in Richtung der Ladungsüberführung durch einen Schnitt getrennt sind, wobei eine gewichtete Ladungsmenge unter jeder Elementarelektrode gesammelt werden kann und wobei die Überführungs- und Wichtungselektroden beim periodischen Anlegen gegebener Potentiale ($\phi_1$, $\phi_2$) die Überführung der Ladungen in dem Substrat gewährleisten.

3. Vorrichtung nach Anspruch 2, dadurch gekennzeichnet, daß die Mittel zum Auslesen gebildet sind aus zwei Ladungslesevorrichtungen ($D_P$, $D_N$), die an zwei Leitungen ($L_P$, $L_N$) zum

Einsammeln der gewichteten Ladungsmengen von zwei Elementarelektroden jeder Wichtungselektrode (20) angekoppelt sind und daß die Mittel, die das Vorzeichen der der Wichtungskoeffizienten festlegen, und die Mittel zum Summieren der gewichteten Ladungen einen Differenzverstärker (4) mit der Verstärkung eins umfassen, welcher die Signale empfängt, die von den Ladungslesevorrichtungen abgegeben werden und das elektrische Ausgangssignal ($S_1$) des Ladungsverschiebungsfilters liefert.

4. Vorrichtung nach Anspruch 2, dadurch gekennzeichnet, daß das Ladungsverschiebefilter positive Wichtungskoeffizienten aufweist, wobei die Mittel zum algebraischen Summieren gebildet sind aus einer Leitung (L) zum Einsammeln der gewichteten Ladungsmengen einer Elementarelektrode jeder Wichtungselektrode (20), und wobei die Mittel zum Auslesen der elektrischen Ladungsmengen und die Mittel, die das Vorzeichen der Wichtungskoeffizienten festlegen, gebildet sind aus einer Ladungsauslesevorrichtung (D), die an die Sammelleitung angekoppelt ist und das elektrische Ausgangssignal des Filters liefert.

5. Vorrichtung nach einem der Ansprüche 1, 2, 3 oder 4, dadurch gekennzeichnet, daß wenigstens ein Analogfilter ein Filter mit geschalteten Kapazitäten ist, das aus wenigstens einem Verstärker (3) und einem Netz von Kapazitäten und MOS-Transistoren, die im Schaltbetrieb arbeiten, gebildet ist, das mit jedem Verstärker verbunden ist und bei welchem die Kombination einer Kapazität und zweier MOS-Transistoren als Widerstand dient.

6. Vorrichtung nach Anspruch 5, dadurch gekennzeichnet, daß jeder Verstärker (3) Kapazitäten ($C_1$, $C_2$) aufweist, die periodisch durch im Schaltbetrieb arbeitende MOS-Transistoren parallel und in Reihe geschaltet werden, wobei dieselbe Spannung gleichzeitig die parallel geschalteten Kapazitäten auflädt und eine verstärkte Spannung zwischen den äußersten Anschlüssen A und B der in Reihe geschalteten Kapazitäten erhalten wird, wobei die Kapazitäten parallel geschaltet werden durch MOS-Transistoren ($T_{11}$, $T_{12}$), die mit ihrer Drain-Elektrode und Source-Elektrode einerseits zwischen einen der Anschlüsse jeder Kapazität, darunter der äußerste Anschluß A der Kapazität $C_1$, und zum anderen den Eingang, an den eine Spannung $E_2$ angelegt ist, geschaltet sind, und durch MOS-Transistoren ($T_{13}$), die mit ihrer Drain-Elektrode und ihrer Source-Elektrode zwischen den anderen Anschluß jeder Kapazität und Masse geschaltet sind, wobei der äußerste Anschluß B direkt mit Masse verbunden ist, und wobei die Kapazitäten in Reihe geschaltet werden durch MOS-Transistoren ($T_2$), die mit ihrer Drain-Elektrode und ihrer Source-Elektrode zwischen die Anschlüsse der Kapazitäten geschaltet sind, die nicht die äußersten Anschlüsse A und B sind, wobei die beiden MOS-Transistorgruppen ($T_{11}$, $T_{12}$, $T_{13}$ ; $T_2$), welche die Parallelschaltung und die Reihenschaltung gewährleisten, durch periodische Signale ($\phi_3$, $\phi_4$) gesteuert sind, die an ihre Gate-Elektroden angelegt sind und derart beschaffen sind, daß die zwei Gruppen nicht gleichzeitig leitend sind, und wobei dieser Verstärker vollständig auf einem selben Halbleitersubstrat integriert sein kann.

7. Vorrichtung nach Anspruch 6, dadurch gekennzeichnet, daß ein MOS-Transistor $T_3$ mit seiner Drain-Elektrode und seiner Source-Elektrode zwischen den äußersten Anschluß A und einen Punkt F geschaltet ist, der den Anschluß einer Kapazität $C_{20}$ bildet, deren anderer Anschluß mit Masse verbunden ist, wobei der MOS-Transistor $T_3$ im Schaltbetrieb arbeitet und durch ein periodisches Signal $\phi_5$ gesteuert ist, das an seine Gate-Elektrode angelegt ist, wobei der Transistor $T_3$ während desjenigen Zeitintervalls leitend gemacht wird, wo die Kapazitäten durch das Signal $\phi_4$ in Reihe geschaltet sind, um die Überführung der verstärkten Spannung vom Anschluß A zu dem Punkt F zu gestatten, und wobei die Kapazität $C_{20}$ die Aufrechterhaltung der verstärkten Spannung am Punkte F und die Einstellung der Verstärkung des Verstärkers gestattet.

8. Vorrichtung nach Anspruch 6 oder 7, dadurch gekennzeichnet, daß die Kapazitäten ($C_1$, $C_2$) des Verstärkers (3) mit einer Kapazität übereinstimmen, die zu dem Netz von Kapazitäten und MOS-Transistoren gehört, das mit jedem Verstärker verbunden ist.

9. Vorrichtung nach einem der Ansprüche 1 bis 8, dadurch gekennzeichnet, daß sie vollständig auf ein und demselben Halbleitersubstrat integriert ist.

FIG_1

0 011 570

# FIG_2

(a)

(b)

(c)

(d)

## FIG_3

## FIG_4